# EUROPEAN PATENT APPLICATION

(11) **EP 2 175 482 A1**
(43) Date of publication of application: **14.04.2010**
(21) Application number: 08764403.5
(22) Date of filing: 20.05.2008
(51) Int. Cl.: H01L 21/677, B65G 49/06, C23C 16/02, C23C 16/44, H01L 21/02, H01L 21/205

(54) **VACUUM PROCESSING DEVICE AND VACUUM PROCESSING METHOD**

(30) Priority: 13.07.2007 JP 2007184317
(71) Applicant: Sharp Kabushiki Kaisha, Osaka-shi, Osaka 545-8522 (JP)
(72) Inventor: FUKUOKA, Yusuke, Osaka-shi, Osaka 545-8522 (JP); KISHIMOTO, Katsushi, Osaka-shi, Osaka 545-8522 (JP)
(74) Representative: Müller - Hoffmann & Partner
(86) International application number: PCT/JP2008/059244
(87) International publication number: WO 2009/011166

(57) **Abstract**

While a workpiece (107) is vacuum-processed in a first processing chamber (101), a workpiece to be processed next is heated at a loading unit (108) of a second processing chamber (102). The vacuum-processed workpiece is unloaded to an unloading unit (119) of the second processing chamber. The loading unit and the unloading unit move in the arrangement direction (Y) perpendicular to the direction of transport (X) of the workpiece by a transport mechanism (202A). The workpiece supported by the loading unit is loaded into the first processing chamber. While the workpiece is vacuum-processed, a new workpiece is supported by the loading unit. The workpiece supported by the unloading unit is removed from the second vacuum chamber, and the new workpiece is preheated.

## Description

### TECHNICAL FIELD

The present invention relates to a vacuum processing device and a vacuum processing method for performing vacuum processing on a preheated workpiece to be processed.

### BACKGROUND ART

Conventional vacuum processing devices for use in deposition and etching of a semiconductor film, an insulating film and a metal film for example generally include a load lock chamber and a vacuum processing chamber. After a substrate is loaded in the load lock chamber, the load lock chamber is evacuated and the substrate is preheated. The substrate heated in the load lock chamber is loaded in the vacuum processing chamber where deposition or etching is performed on the substrate. In such a vacuum processing device, it is required to successively process substrates in the vacuum processing chamber and it is required to successively feed preheated substrates to the vacuum processing chamber in order to improve the production efficiency. To meet such requirements, a vacuum processing device further including an unload lock chamber to which substrates are unloaded from the vacuum processing chamber is used.

Japanese Patent Laying-Open No. 2001-239144 (Patent Document 1) discloses a vacuum processing device including a vacuum preheating chamber serving as both of a load lock chamber and an unload lock chamber. The vacuum processing device with this configuration has an advantage that the area occupied by the vacuum processing device can be reduced. The vacuum processing device disclosed in Japanese Patent Laying-Open No. 2001-239144 (Patent Document 1) also includes a vacuum preheating unit for preheating a substrate, and a processing chamber for processing a substrate transported from the vacuum preheating unit, and uses any substrate transport means among a plurality of substrate transport means in the vacuum preheating unit to transport a substrate having been processed in the processing chamber. Accordingly, while a substrate is processed in the processing chamber, another substrate can be preheated in the vacuum preheating chamber and, while the processed substrate is removed from the processing chamber, the preheated substrate can be transferred into the processing chamber. In other words, this vacuum processing device has an effect of improving the production efficiency by shortening the waiting time for preheating.

Specifically, two sets of substrate transport systems are provided at the vacuum preheating unit, and a lifter is raised and lowered to make a switch between the systems. Heaters are placed above the upper substrate transport system and below the lower substrate transport system, respectively. Therefore, while vacuum processing is performed in the processing chamber, any of the substrate transport systems of the vacuum preheating unit can be used to preheat a substrate to be processed next.
Patent Document 1: Japanese Patent Laying-Open No. 2001-239144
Patent Document 2: International Patent Publication No. WO2005/074020

### DISCLOSURE OF THE INVENTION

### PROBLEMS TO BE SOLVED BY THE INVENTION

In the vacuum device disclosed in Japanese Patent Laying-Open No. 2001-239144 (Patent Document 1), a substrate mounted on the upper substrate transport system is preheated from above the substrate, and a substrate mounted on the lower substrate transport system is preheated from below the substrate. A resultant disadvantage is that the temperature distribution of a surface to be vacuum-processed of a substrate transported from the upper substrate system into the processing chamber and that of a substrate transported from the lower substrate transport system into the processing chamber are different from each other. In other words, because respective preheating temperatures of substrate surfaces to be vacuum-processed are different from each other depending on which transport path is used to transport the substrate, respective temperature conditions of substrate surfaces to be vacuum-processed are different from each other, resulting in difficulty in producing uniform vacuum-processed workpieces.

The difference in temperature condition is particularly noticeable in the case where substrates with a large heat capacity are used. In other words, substrates with a smaller heat capacity are unlikely to be different from each other in terms of the temperature of a surface to be processed, regardless of which of the upper surface and the lower surface of a substrate is directly heated. In contrast, in the case of substrates with a larger heat capacity, the front side of a substrate whose rear side is directly heated is smaller in temperature increase, and thus a temperature difference is likely to occur between the front side and the rear side of the substrate.

The present invention has been made to solve the problems, and a chief object of the invention is to provide a vacuum processing device and a vacuum processing method with which a difference in temperature distribution between workpieces to be vacuum-processed can be reduced.

### MEANS FOR SOLVING THE PROBLEMS

According to an aspect of the present invention, a vacuum processing device for performing vacuum processing on a workpiece is provided. The vacuum processing device includes a first processing chamber for housing the workpiece and performing vacuum processing on the workpiece. The first processing chamber includes a vacuum processing unit for supporting the workpiece and performing vacuum processing on the workpiece. The vacuum processing device further includes an evacuatable second processing chamber for housing a workpiece to be vacuum-processed and a workpiece having been vacuum-processed. The second processing chamber includes a loading unit for supporting the workpiece to be vacuum-processed. The loading unit has a heating device for heating the workpiece to be vacuum-processed. The second processing chamber further includes an unloading unit for supporting the workpiece having been vacuum-processed. The vacuum processing device further includes a gate unit provided between the first processing chamber and the second processing chamber and capable of blocking and allowing communication between the first processing chamber and the second processing chamber, and a transport mechanism for transporting the workpiece to be vacuum-processed from the loading unit to the vacuum processing unit through the gate unit and transporting the workpiece having been vacuum-processed from the vacuum processing unit to the unloading unit through the gate unit.

According to this aspect, the workpiece is heated at the loading unit before being loaded from the second processing chamber to the first processing chamber, and unloaded to the unloading unit when the workpiece is loaded from the first processing chamber to the second processing chamber. In other words, all workpieces are vacuum-processed through the same path. Thus, respective preheating temperatures and respective preheating temperature distributions of workpieces are uniform, and a difference in temperature distribution between workpieces to be vacuum-processed can be reduced. Accordingly, the precision and reliability of vacuum processing are improved.

Preferably, the loading unit and the unloading unit are arranged so that the loading unit and the unloading unit are spaced by a predetermined distance in an arrangement direction substantially perpendicular to a direction of loading the workpiece. The loading and unloading units and the vacuum processing unit are relatively movable by a relative distance in a relative direction of a pair of the loading unit and the unloading unit delivering and receiving the same workpiece via the vacuum processing unit.

Preferably, the first processing chamber includes a plurality of vacuum processing units disposed in the arrangement direction. The second processing chamber includes a plurality of loading units disposed in the arrangement direction, and a plurality of unloading units disposed in the arrangement direction. The plurality of loading units are substantially identical in terms of relative positional relation between a surface to be processed of the workpiece supported by the loading unit and the heating device.

Preferably, an interval at which the plurality of loading units are arranged, an interval at which the plurality of unloading units are arranged and an interval at which the plurality of vacuum processing units are arranged are substantially identical.

Preferably, the loading units and the unloading units are disposed alternately in the arrangement direction.

Preferably, the second processing chamber further includes a door for feeding and removing the workpiece. The door has a dimension in the arrangement direction larger than a dimension in the arrangement direction of a portion where the loading unit and the unloading unit are arranged.

Preferably, the transport mechanism includes a first transport device disposed at the vacuum processing unit. The first transport device supports the workpiece to be vacuum-processed. The transport mechanism further includes a second transport device disposed at the loading unit. The second transport device supports a workpiece to be vacuum-processed. The first transport device and the second transport device load the workpiece to be vacuum-processed from the loading unit to the vacuum processing unit. The transport mechanism further includes a third transport device disposed at the unloading unit. The third transport device supports the workpiece having been vacuum-processed. The first transport device and the third transport device unload the workpiece having been vacuum-processed from the vacuum processing unit to the unloading unit.

Preferably, the transport mechanism includes first transport devices disposed at the vacuum processing units, respectively. The first transport devices support the workpieces to be vacuum-processed, respectively. The transport mechanism further includes second transport devices disposed at the loading units, respectively. The second transport devices support workpieces to be vacuum-processed, respectively. The first transport devices and the second transport devices simultaneously load the workpieces to be vacuum-processed from the loading units to the vacuum processing units. The transport mechanism further includes third transport devices disposed at the unloading units, respectively. The third transport devices support workpieces having been vacuum-processed, respectively. The first transport devices and the second transport devices simultaneously unload the workpieces having been vacuum-processed from the vacuum processing units to the unloading units.

According to another aspect of the present invention, a vacuum processing method for performing vacuum processing on a workpiece in a first processing chamber after heating the workpiece in a second processing chamber is provided. The second processing chamber includes a loading unit and an unloading unit spaced by a predetermined distance in an arrangement direction in the second processing chamber. The vacuum processing method includes the steps of: disposing a workpiece to be vacuum-processed in the loading unit; evacuating the second processing chamber and heating the workpiece supported by the loading unit; loading the workpiece to be vacuum-processed from the loading unit into the first processing chamber; vacuum-processing the workpiece in the first processing chamber; moving the loading unit and the unloading unit in the arrangement direction; unloading the workpiece having been vacuum-processed from inside of the first processing chamber to the unloading unit; opening the second processing chamber to atmosphere; removing the workpiece having been vacuum-processed from the unloading unit; and secondarily moving the loading unit and the unloading unit in a relative direction of the unloading unit with respect to the loading unit. The step of opening the second processing chamber to atmosphere, the step of removing the workpiece having been vacuum-processed, the step of disposing the workpiece, and the step of heating the workpiece are executed while the step of vacuum processing the workpiece is performed. The step of unloading the workpiece, the step of moving the loading unit and the unloading unit and the step of loading the workpiece are executed after the step of vacuum-processing the workpiece.

According to still another aspect of the present invention, a vacuum processing method using a vacuum processing device for performing vacuum processing on a workpiece in a first processing chamber after preheating the workpiece in a second processing chamber is provided. The vacuum processing device includes the first processing chamber for housing the workpiece and performing vacuum processing on the workpiece. The first processing chamber includes a vacuum processing unit for supporting the workpiece and performing vacuum processing on the workpiece. The vacuum processing device further includes the second processing chamber evacuatable and housing a workpiece to be vacuum-processed and a workpiece having been vacuum-processed. The second processing chamber includes a loading unit for supporting the workpiece to be vacuum-processed. The loading unit has a heating device for heating the workpiece to be vacuum-processed. The second processing chamber further includes an unloading unit for supporting the workpiece having been vacuum-processed. The vacuum processing device further includes a transport mechanism for transporting the workpiece to be vacuum-processed from the loading unit to the vacuum processing unit and transporting the workpiece having been vacuum-processed from the vacuum processing unit to the unloading unit. The loading and unloading units and the vacuum processing unit are relatively movable. The vacuum processing method includes the steps of: heating the workpiece to be vacuum-processed by the heating device; unloading the workpiece having been vacuum-processed from the vacuum processing unit to the unloading unit by the transport mechanism; moving the loading unit and the unloading unit in a relative direction of the unloading unit with respect to the loading unit; and loading a workpiece to be vacuum-processed from the loading unit to the vacuum processing unit by the transport mechanism.

### EFFECTS OF THE INVENTION

In this way, a difference in temperature distribution between workpieces to be vacuum-processed can be reduced.

### BRIEF DESCRIPTION OF THE DRAWINGS

Fig. 1 is a schematic plan view showing a vacuum processing device according to a first embodiment.
Fig. 2 is a functional block diagram showing a functional configuration of the vacuum processing device according to the first embodiment.
Fig. 3 is a schematic showing a workpiece and a transport mechanism.
Fig. 4 is a flowchart for a vacuum processing method according to the first embodiment.
Fig. 5 shows flowcharts for a placement step and a placement and removal step.
Fig. 6 is a schematic plan view showing the vacuum processing device after a workpiece unloading step.
Fig. 7 is a schematic plan view showing the vacuum processing device after a workpiece loading step.
Fig. 8 is a schematic plan view showing the vacuum processing device after a workpiece removal step.
Fig. 9 is a schematic plan view showing the vacuum processing device after a workpiece placement step.
Fig. 10 is a schematic plan view showing the vacuum processing device after a loading unit and unloading unit movement step.
Fig. 11 is a schematic cross-sectional plan view showing a vacuum processing device according to a second embodiment.
Fig. 12 is a schematic cross-sectional plan view showing a vacuum processing device according to a third embodiment.
Fig. 13 is a schematic cross-sectional plan view showing a vacuum processing device according to a fourth embodiment.
Fig. 14 is a schematic front view showing a first modification of the transport mechanism.
Fig. 15 is a cross section along arrow-headed line A-A in Fig. 14 (d).
Fig. 16 is a schematic front view showing a second modification of the transport mechanism.

### DESCRIPTION OF REFERENCE SIGNS

1A, 1B, 1C, 1D, 1E vacuum processing device, 12a, 12b rail, 50 tray, 60 transport arm, 63 arm unit, 101 first processing chamber (vacuum processing chamber), 102 second processing chamber (preparatory vacuum chamber), 103 gate valve, 104 vacuum processing unit, 107 workpiece, 107a workpiece surface to be processed, 108 loading unit, 111 heating device, 114 placement and removal door, 119 unloading unit, 202 transport mechanism

### BEST MODES FOR CARRYING OUT THE INVENTION

Embodiments of the present invention will be hereinafter described based on the drawings. In the following description, like components are denoted by like reference characters. Where components have like names or functions, a detailed description of the components will not be repeated.

### First Embodiment

### Vacuum Processing Device

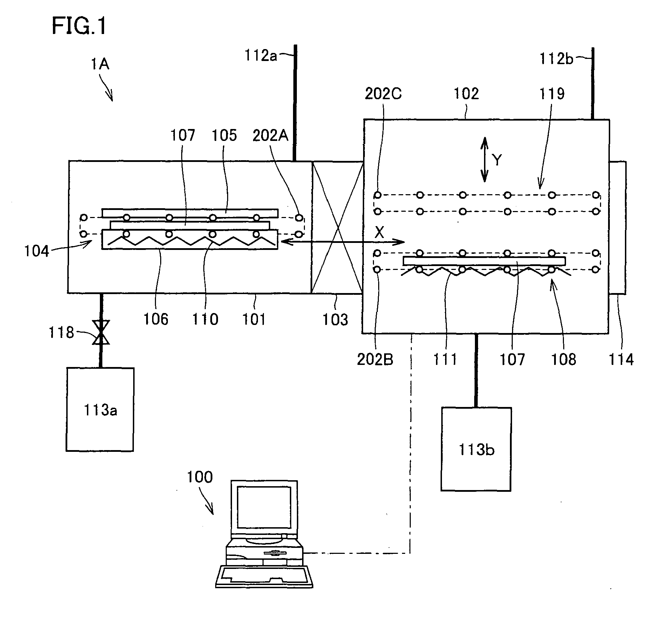

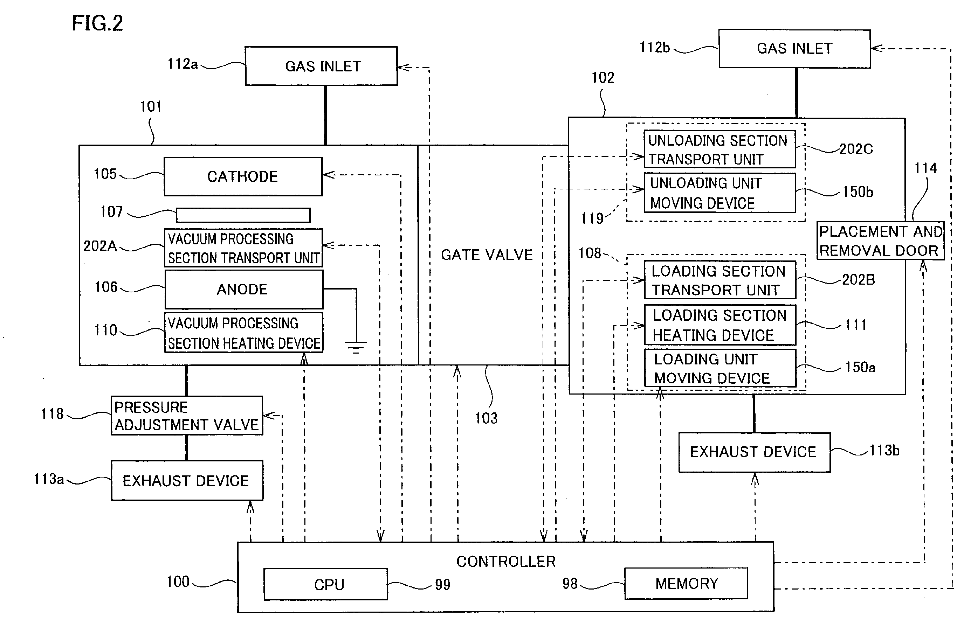

A vacuum processing device 1A of a first embodiment will be described first with reference to drawings. Fig. 1 is a schematic plan view showing vacuum processing device 1A of the present embodiment, and Fig. 2 is a functional block diagram showing a functional configuration of vacuum processing device 1A of the present embodiment.

As shown in Figs. 1 and 2, vacuum processing device 1A includes a vacuum processing chamber 101 where vacuum processing is performed, and a preparatory vacuum chamber 102 that can be evacuated, and the former chamber and the latter chamber are connected via a gate valve 103. Vacuum processing chamber 101 is connected to an evacuation device 113a for evacuating the inside of vacuum processing chamber 101. Preparatory vacuum chamber 102 is connected to an evacuation device 113b for evacuating the inside of preparatory vacuum chamber 102. Vacuum pumps or the like are used for evacuation devices 113a, 113b.

In vacuum processing chamber 101, a pair of a cathode electrode 105 and an anode electrode 106 with a parallel flat electrode structure is provided. Cathode electrode 105 is supplied with alternating current power. Anode electrode 106 is grounded. In vacuum processing chamber 101, a vacuum processing section heating device 110 for heating a workpiece 107 to be processed is placed on anode electrode 106 side of a vacuum processing unit 104. For vacuum processing section heating device 110, a lamp heater or a heater using heat generated from a resistor is generally used. It should be noted, however, it is not necessary that vacuum processing section heating device 110 is integrated with anode electrode 106, and may be placed separately from anode electrode 106. Workpiece 107 is placed so that workpiece 107 is located in parallel with and is electrically connected to anode electrode 106.

Vacuum processing chamber 101 has a gas inlet 112a for introducing a gas used for vacuum processing such as plasma processing. Between evacuation device 113a and vacuum processing chamber 101, a pressure adjustment valve 118 is provided for keeping constant the pressure, in vacuum processing chamber 101, of the gas introduced from gas inlet 112a into vacuum processing chamber 101.

In the present embodiment, workpiece 107 is plasma-processed (vacuum-processed) with a plasma generated between cathode electrode 105 and anode electrode 106. In other words, vacuum processing unit 104 in the present embodiment includes cathode electrode 105 and anode electrode 106. While the vacuum processing may be deposition by plasma CVD (Chemical Vapor Deposition) for example, the vacuum processing is not limited to this and may be deposition by sputtering or vapor deposition, or plasma etching, for example.

In preparatory vacuum chamber 102, a loading unit 108 including a heater (loading section heating device) 111 is provided for preheating workpiece 107. In loading unit 108, workpiece 107 to be vacuum-processed in vacuum processing chamber 101 is disposed. In preparatory vacuum chamber 102, an unloading unit 119 is also provided for housing workpiece 107 that has been vacuum-processed in vacuum processing chamber 101. Loading unit 108 and unloading unit 119 are spaced by a predetermined distance along the direction (along top-bottom direction Y as seen in Fig. 1, which is also referred to as arrangement direction Y) perpendicular to transport direction X of workpiece 107, and are configured so that loading unit 108 and unloading unit 119 are movable by a predetermined distance in arrangement direction Y.

Loading unit 108 and unloading unit 119 may be configured so that they can be moved independently of each other in Y direction or together in Y direction, by a loading unit moving device 150a and an unloading unit moving device 150b, respectively. In order to simplify the device configuration of vacuum processing device 1A itself, it is desirable that loading unit moving device 150a and unloading unit moving device 150b operate in cooperation with each other so as to enable loading unit 108 and unloading unit 119 to move together. Specifically, loading unit 108 and unloading unit 119 may be configured for example so that they are supported by the same frame that slides on rails disposed in Y direction.

In particular, direction Y of moving loading unit 108 and unloading unit 119 is preferably perpendicular to direction X of transporting workpiece 107. This direction of moving these units may be Y direction in Fig. 1, or the direction perpendicular to the plane of Fig. 1 (the direction perpendicular to both of transport direction X and Y direction in Fig. 1, referred to as Z direction hereinafter). In other words, the direction of moving loading unit 108 and unloading unit 119 may be any as long as loading unit 108 and unloading unit 119 can move to respective positions where workpiece 107 is easily delivered to and received from a transport device 202A of vacuum processing unit 104 as described later. It is preferable that loading unit 108 and unloading unit 119 are disposed (arranged) in a direction including at least one of the Y direction component and the Z direction component so that loading unit 108 and unloading unit 119 can move in the direction.

In the present embodiment, it is supposed that Fig. 1 is a plan view and Z direction is the vertical direction. Alternatively, Fig. 1 may be a side view and Y direction may be the vertical direction.

Preparatory vacuum chamber 102 has a gas inlet 112b for gradually introducing a leak gas when the inside of preparatory vacuum chamber 102 is opened to the atmosphere. At a part of the outer wall of preparatory vacuum chamber 102, a placement and removal door 114 is provided for transferring workpiece 107 from the outside to the inside and vice versa.

In the present embodiment, placement and removal door 114 is positioned and sized to enable an operator for example to transfer through the door workpiece 107 from the outside and from the inside by moving loading unit 108 and unloading unit 119 to predetermined positions, respectively. It should be noted that placement and removal door 114 is desirably positioned and sized to enable an operator for example to convey through the door workpiece 107 to be contained or contained in loading unit 108 or unloading unit 119, without moving loading unit 108 and unloading unit 119, as described later. In other words, placement and removal door 114 is preferably formed so that the dimension in arrangement direction Y of the door is longer than the dimension in arrangement direction Y of the area where loading unit 108 and unloading unit 119 are arranged. In this case, a user having placed workpiece 107 at loading unit 108 can remove workpiece 107 from unloading unit 119 without moving loading unit 108 and unloading unit 119.

Gate valve 103 provided between vacuum processing chamber 101 and preparatory vacuum chamber 102 can be opened and closed. Gate valve 103 is opened to allow the inside of vacuum processing chamber 101 and the inside of preparatory vacuum chamber 102 to communicate with each other. With the vacuum state maintained, workpiece 107 can be transported between vacuum processing chamber 101 and preparatory vacuum chamber 102.

Vacuum processing chamber 101 and preparatory vacuum chamber 102 are provided with a transport mechanism. The transport mechanism may be any as long as the transport mechanism can transport workpiece 107 from loading unit 108 to vacuum processing unit 104 and transport workpiece 107 from vacuum processing unit 104 to unloading unit 119. The transport mechanism may be provided at one or both of vacuum processing chamber 101 and preparatory vacuum chamber 102.

In the present embodiment, loading unit 108 and unloading unit 119 are movable in a relative direction of these units (arrangement direction Y), vacuum processing unit 104 and loading unit 108 can be aligned linearly in transport direction X of workpiece 107, and vacuum processing unit 104 and unloading unit 119 can be aligned linearly in transport direction X thereof. In other words, vacuum processing device 1A includes means for moving loading unit 108 and unloading unit 119, and can linearly transport - workpiece 107 by means of the transport mechanism as described above.

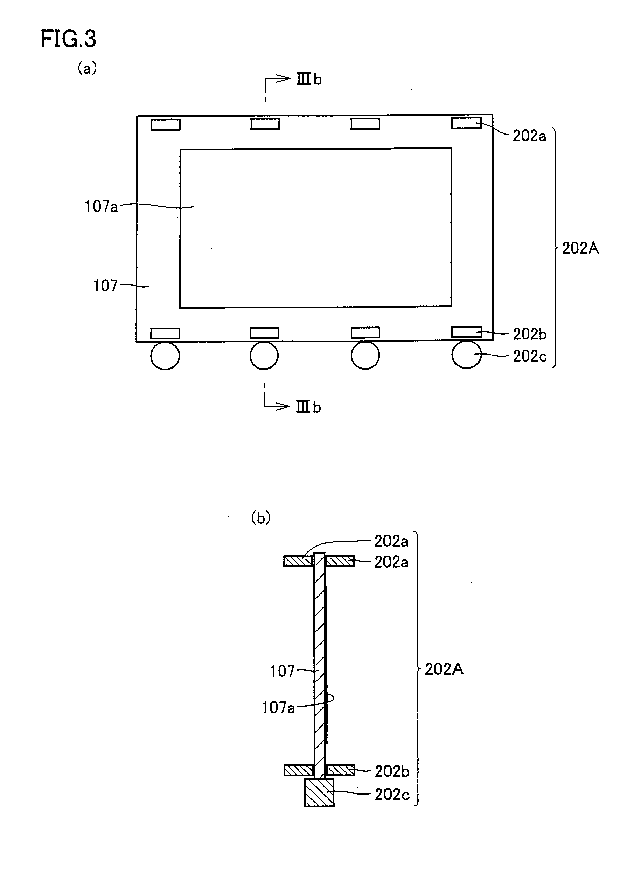

A configuration of the transport mechanism in the present embodiment will be hereinafter described with reference to drawings. Fig. 3 (a) is a side view of workpiece 107 and the transport mechanism as seen from a surface 107a to be processed of workpiece 107, and Fig. 3 (b) is a schematic cross section along arrow-headed line IIIb-IIIb in Fig. 3 (a).

As shown in Figs. 1 and 2, the transport mechanism of the present embodiment includes a loading section transport device 202B provided at loading unit 108 for holding workpiece 107 to be vacuum-processed, an unloading section transport device 202C provided at unloading unit 119 for holding workpiece 107 having been vacuum-processed, and a vacuum-processing section transport device 202A provided at vacuum processing unit 104 for holding vacuum-processed workpiece 107. Respective configurations of transport devices 202A, 202B, 202C are substantially identical to each other, and therefore, a description will be given below of vacuum-processing section transport device 202A provided at vacuum processing unit 104.

As shown in Fig. 3 (a) and Fig. 3 (b), workpiece 107 is mounted on drive rollers 202c with the rotational axis in the horizontal direction. The lateral sides of workpiece 107 are laterally supported by driven rollers 202a and driven rollers 202b. Drive rollers 202c are rotated by a motor or the like for moving workpiece 107 linearly in transport direction X.

Vacuum processing device 1A of the present embodiment configured in the above-described manner can transport workpiece 107 to be vacuum-processed to vacuum processing unit 104 so that workpiece surface 107a can be vacuum-processed, and transport workpiece 107 having been vacuum-processed to unloading unit 119. Specifically, transport device 202B of loading unit 108 and transport device 202A of vacuum processing unit 104 transport workpiece 107 to be vacuum-processed from loading unit 108 to vacuum processing unit 104, and transport device 202A of vacuum processing unit 104 and transport device 202C of unloading unit 119 transport workpiece 107 having been vacuum-processed from vacuum processing unit 104 to unloading unit 119. In the case where workpiece 107 is to be linearly moved along transport direction X, a transport system of a simple configuration may be employed, using rollers 202a, 202b, guide, rail, and groove for example and applying thrust to workpiece 107 by means of a motor or the like as described above.

In the present embodiment, workpiece 107 is placed so that workpiece surface 107a to be processed is perpendicular to the horizontal plane. Workpiece 107, however, may be held at any angle as described above.

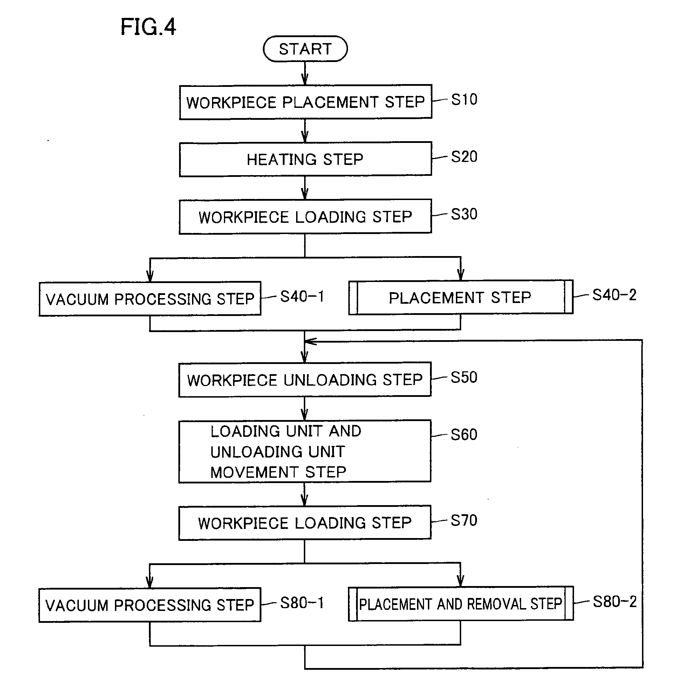

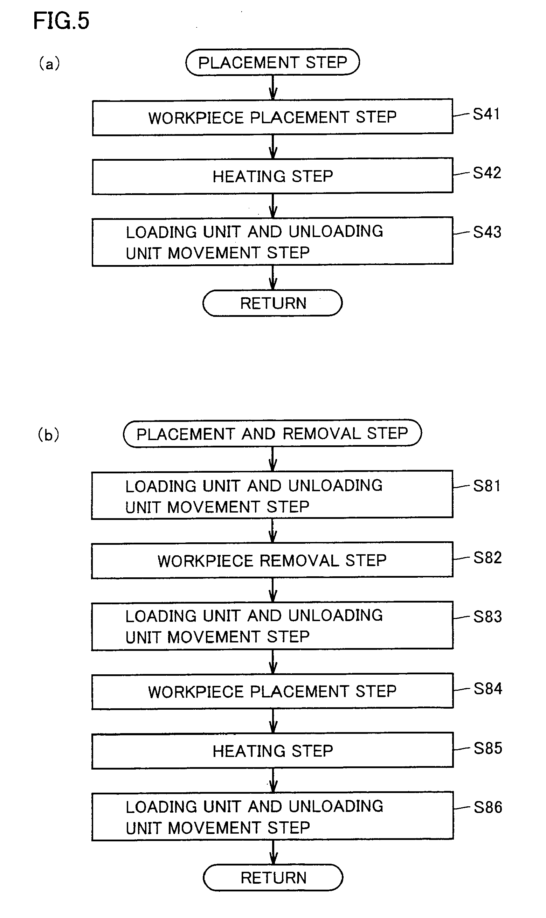

An embodiment of a vacuum processing method using vacuum processing device 1A of the present embodiment will be described hereinafter with reference to drawings. Fig. 4 is a flowchart for the vacuum processing method of the present embodiment. Fig. 5 (a) is a flowchart for a placement step, and Fig. 5 (b) is a flowchart for a placement and removal step. As shown in Fig. 2, the components of vacuum processing device 1A are each connected via a cable or interface to a controller 100, and the following steps are mainly carried out through operation of controller 100. Specifically, controller 100 includes therein a memory 98 where a program for controlling vacuum processing device 1A is stored, and a CPU 99 reading the program for controlling vacuum processing device 1A. In the present embodiment, the vacuum processing performed by vacuum processing device 1A is controlled by software executed on controller 100.

WORKPIECE PLACEMENT STEP: As shown in Fig. 4, controller 100 first causes a leak by opening gas inlet 112b to introduce nitrogen gas into preparatory vacuum chamber 102. When the inside of preparatory vacuum chamber 102 reaches the atmospheric pressure, placement and removal door 114 is opened so as to open the inside of preparatory vacuum chamber 102 to the atmosphere. In this state, workpiece 107 to be vacuum-processed is disposed at loading unit 108. After workpiece 107 is disposed at loading unit 108, placement and removal door 114 is hermetically closed (step 10, step is hereinafter abbreviated as S).

HEATING STEP: Next, evacuation device 113b is activated to evacuate the inside of preparatory vacuum chamber 102. At the same time, heater 111 is turned on to heat workpiece 107 (S20).

WORKPIECE LOADING STEP: After the temperature of workpiece 107 reaches a predetermined temperature and the degree of vacuum of the inside of preparatory vacuum chamber 102 reaches a predetermined degree of vacuum, gate valve 103 for allowing and blocking communication between vacuum processing chamber 101 and preparatory vacuum chamber 102 is opened. While the vacuum of respective insides of vacuum processing chamber 101 and preparatory vacuum chamber 102 is maintained, the transport mechanism loads workpiece 107 to be vacuum-processed from loading unit 108 in preparatory vacuum chamber 102 to vacuum processing unit 104 in vacuum processing chamber 101 (S30). After workpiece 107 is loaded in vacuum processing unit 104, heater 111 is turned off and gate valve 103 is closed. As for the timing at which loading unit 108 is moved to a predetermined position for transporting the workpiece (the position where loading unit 108 and vacuum processing unit 104 are linearly aligned), the timing may be before, after or while gate valve 103 is opened.

VACUUM PROCESSING STEP: Controller 100 causes a voltage to be applied to the cathode side to deposit a silicon film for example by plasma CVD or the like on workpiece 107 loaded in vacuum processing unit 104 (S40-1). While vacuum processing device 1A is operating, vacuum processing section heating device 110 in vacuum processing chamber 101 is kept supplied with electric power, and the output of the heating device is controlled by controller 100 so that the temperature of workpiece 107 is kept for example at 170°C.

Specifically, after gate valve 103 is closed, a reaction gas constituted of hydrogen gas and silane gas is introduced from gas inlet 112a into vacuum processing chamber 101. Pressure adjustment valve 118 is used to adjust the pressure in vacuum processing chamber 101 to a predetermined pressure. Then, high-frequency power (frequency of 13.56 MHz for example) is fed to cathode electrode 105 to generate a plasma between cathode electrode 105 and anode electrode 106. The plasma decomposes the reaction gas and accordingly the silicon film is formed on workpiece 107. After the silicon film of a predetermined thickness is formed, controller 100 causes power feeding to cathode electrode 105 to be stopped. Controller 100 also causes introduction of the reaction gas to be stopped so as to evacuate the inside of vacuum processing chamber 101.

WORKPIECE PLACEMENT STEP: In preparatory vacuum chamber 102, as shown in Fig. 4 and Fig. 5 (a), after the temperature of unloading unit 119 decreases to a predetermined temperature, controller 100 causes a leak by introducing nitrogen gas from gas inlet 112b into preparatory vacuum chamber 102. After the inside of preparatory vacuum chamber 102 reaches the atmospheric pressure, placement and removal door 114 is opened so as to open the inside of preparatory vacuum chamber 102 to the atmosphere. After workpiece 107 to be vacuum-processed is disposed at loading unit 108, placement and removal door 114 is hermetically closed (S41).

The workpiece placement step (S41), heating step (S42) and loading unit and unloading unit movement step (S43) (these steps are collectively referred to as placement step S40-2) are carried out in parallel while the vacuum-processing step (S40-1) is performed as shown in Fig. 4.

HEATING STEP: Next, controller 100 causes evacuation device 113b to be activated so as to start evacuating the inside of preparatory vacuum chamber 102. Then, controller 100 causes heater 111 to be turned on so that workpiece 107 to be vacuum-processed is heated (S42).

LOADING UNIT AND UNLOADING UNIT MOVEMENT STEP: Next, in order to allow workpiece 107 having been vacuum-processed to be transported linearly along transport direction X from vacuum processing unit 104 to unloading unit 119, loading unit 108 and unloading unit 119 move in direction Y perpendicular to the direction in which workpiece 107 is transported (S43). Namely, controller 100 makes arrangements so that vacuum processing unit 104 and unloading unit 119 are aligned on an axis in transport direction X. It should be noted that this step may be performed at any time after the workpiece placement step (S41), and may be performed while workpiece 107 is heated by heater 111.

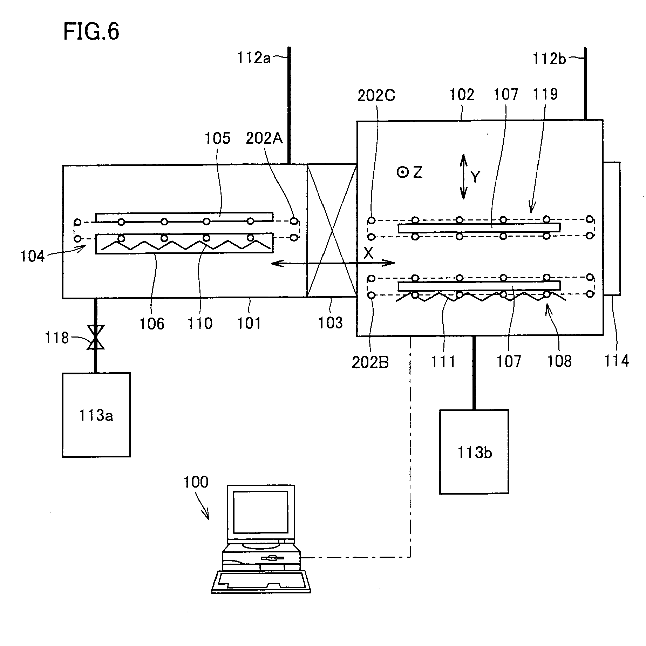

WORKPIECE UNLOADING STEP: After the temperature of workpiece 107 to be vacuum-processed in preparatory vacuum chamber 102 reaches a predetermined temperature, the degree of vacuum of the inside of preparatory vacuum chamber 102 reaches a predetermined degree of vacuum, the vacuum processing step in vacuum processing chamber 101 is completed, and the pressure in vacuum processing chamber 101 reaches a desired pressure, gate valve 103 allowing communication between vacuum processing chamber 101 and preparatory vacuum chamber 102 is opened. Next, transport device 202C and transport device 202B transport vacuum-processed workpiece 107 linearly from vacuum processing unit 104 to unloading unit 119 (S50). Fig. 6 is a schematic plan view showing vacuum processing device 1A after the workpiece unloading step.

LOADING UNIT AND UNLOADING UNIT MOVEMENT STEP: Next, in order to move workpiece 107 to be vacuum-processed that is housed in loading unit 108 linearly to vacuum processing unit 104 by transport device 202A, namely in order to align loading unit 108 and vacuum processing unit 104 on an axis, controller 100 causes loading unit 108 and unloading unit 119 to move in direction Y perpendicular to transport direction X of workpiece 107 (S60).

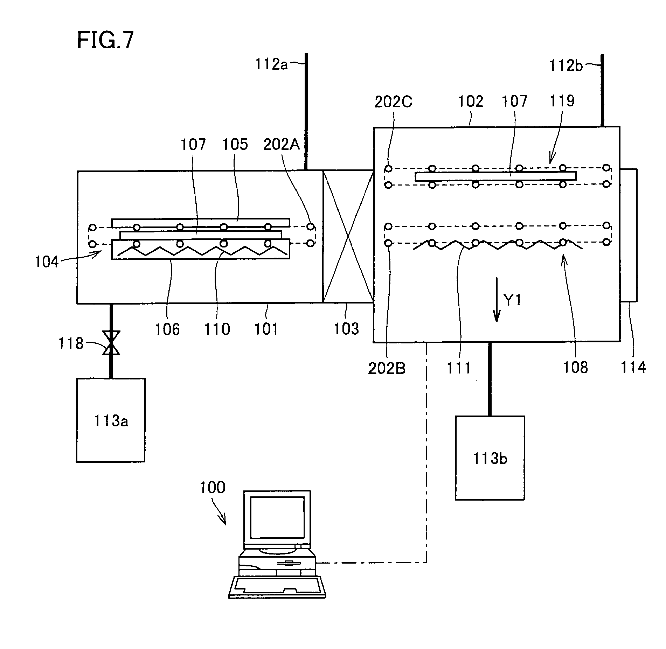

WORKPIECE LOADING STEP: Next, vacuum processing section transport device 202A and loading section transport device 202B load workpiece 107 to be vacuum-processed, by linearly transferring the workpiece from loading unit 108 to vacuum processing unit 104 (S70). Fig. 7 is a schematic plan view showing vacuum processing device 1A after the workpiece loading step. After workpiece 107 to be vacuum-processed is loaded into vacuum processing unit 104, gate valve 103 is hermetically closed, and heater 111 is turned off.

VACUUM PROCESSING STEP: In a similar manner to the above-described one, a silicon film is formed by plasma CVD on workpiece 107 to be vacuum-processed that has been loaded in vacuum processing unit 104 (S80-1). In this step, the same processing as that of the vacuum processing step (S40-1) is carried out. As shown in Fig. 4 and Fig. 5 (b), while this step (S40-1) is performed, the following loading unit and unloading unit movement step (S81), the workpiece removal step (S82), the loading unit and unloading unit movement step (S83), the workpiece placement step (S84), the heating step (S85), and the loading unit and unloading unit movement step (S86) are performed in parallel.

LOADING UNIT AND UNLOADING UNIT MOVEMENT STEP: Loading unit 108 and unloading unit 119 move in the direction (Y1 direction in Fig. 7) perpendicular to transport direction X, so that workpiece 107 having been vacuum-processed can be removed from preparatory vacuum chamber 102 to the outside. As described above, loading unit 108 and unloading unit 119 may be moved together in Y1 direction, or moved separately in Y1 direction (S81).

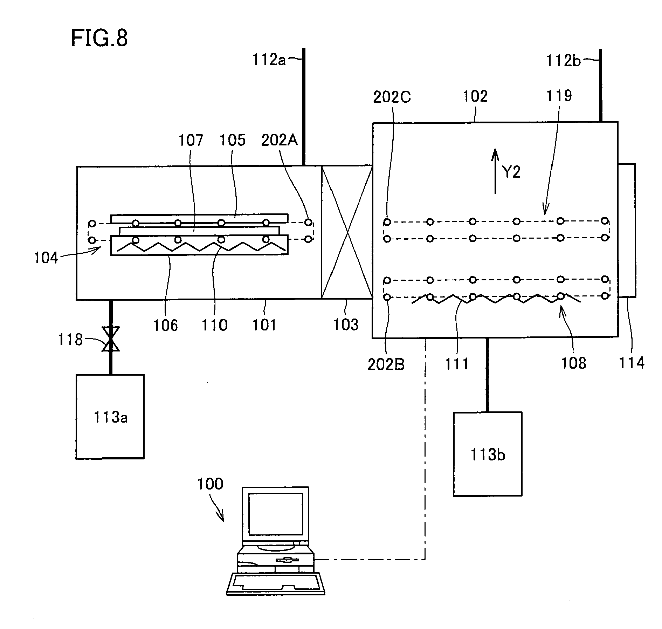

WORKPIECE REMOVAL STEP: When the temperature of vacuum-processed workpiece 107 with the silicon film formed thereon decreases to a predetermined temperature, gas inlet 112b allows nitrogen gas to be introduced into preparatory vacuum chamber 102 for causing a leak. When the inside of preparatory vacuum chamber 102 becomes substantially identical to the atmospheric pressure, placement and removal door 114 is opened so as to open preparatory vacuum chamber 102 to the atmosphere, and vacuum-processed workpiece 107 is removed from unloading unit 119 (S82). Fig. 8 is a schematic plan view showing vacuum processing device 10A after the workpiece removal step.

LOADING UNIT AND UNLOADING UNIT MOVEMENT STEP: Then, in order that workpiece 107 to be vacuum-processed may be conveyed from the outside and placed in preparatory vacuum chamber 102, loading unit 108 and unloading unit 119 move in the direction (Y2 direction in Fig. 8) perpendicular to the direction in which workpiece 107 is transported (S83).

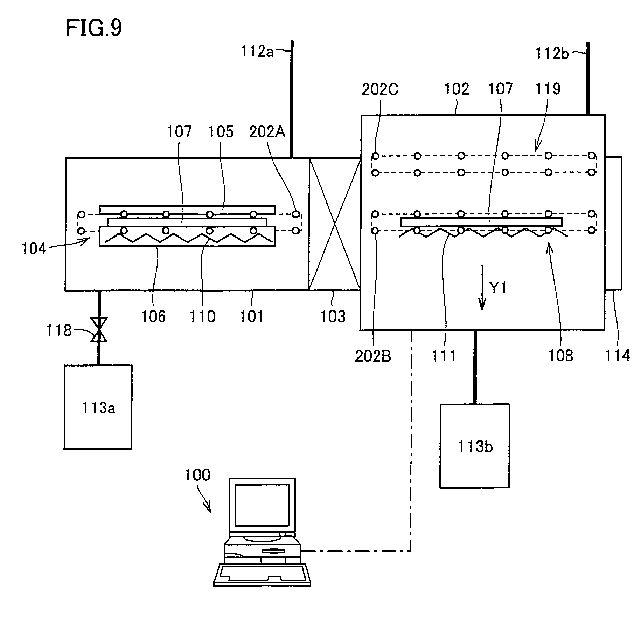

WORKPIECE PLACEMENT STEP: After workpiece 107 to be vacuum-processed is placed at loading unit 108, placement and removal door 114 is hermetically closed (S84). Fig. 9 is a schematic plan view showing vacuum processing device 1A after the workpiece placement step.

HEATING STEP: Next, controller 100 causes evacuation of the inside of preparatory vacuum chamber 102 to be started. Controller 100 causes heater 111 to be turned on so that workpiece 107 to be vacuum-processed is heated at loading unit 108 (S85).

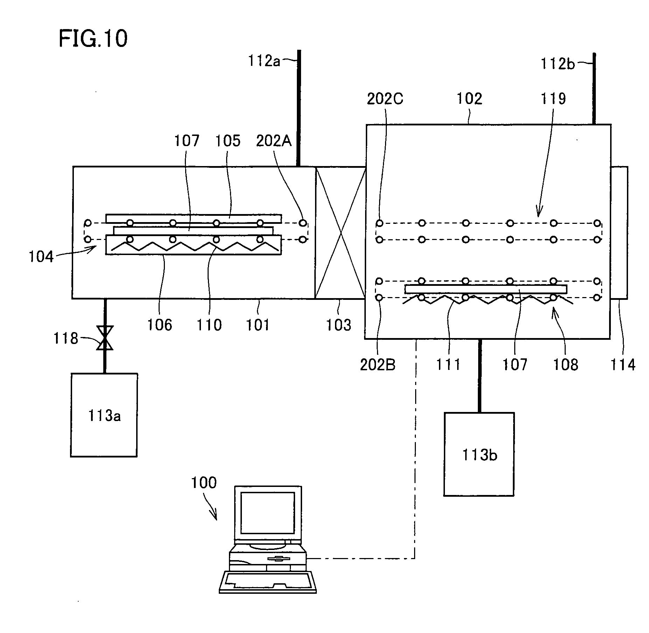

LOADING UNIT AND UNLOADING UNIT MOVEMENT STEP: Next, in order that vacuum-processed workpiece 107 may be unloaded linearly from vacuum processing unit 104 to unloading unit 119, loading unit 108 and unloading unit 119 move in direction Y1 perpendicular to transport direction X of workpiece 107. In other words, controller 100 causes vacuum processing unit 104 and unloading unit 119 to be aligned on an axis in transport direction X (S86). Fig. 10 is a schematic plan view showing vacuum processing device 1A after the loading unit and unloading unit movement step.

Controller 100 thereafter repeats the steps from the workpiece unloading step (S50) to the loading unit and unloading unit movement step (S86) (Figs. 6 to 10). Such a series of steps can be performed to efficiently replace workpieces 107 to be vacuum-processed in vacuum processing unit 104, cool previously vacuum-processed workpiece 107 and heat workpiece 107 to be vacuum-processed next, while the vacuum processing step is performed. Accordingly, the cycle time (the time required for processing one workpiece 107) of vacuum processing device 1A can be shortened.

Regarding the vacuum processing device and the vacuum processing method of the present embodiment, workpiece 107 to be vacuum-processed is heated at loading unit 108 in preparatory vacuum chamber 102, and thereafter loaded into and vacuum-processed at vacuum processing unit 104 in vacuum processing chamber 101. Workpiece 107 having been vacuum-processed is unloaded from vacuum processing unit 104 in vacuum processing chamber 101 to unloading unit 119 in preparatory vacuum chamber 102. Thus, workpieces 107 are vacuum-processed while transferred through the same path, and therefore, respective temperature conditions of workpieces 107 are not different from each other. In other words, vacuum processing device 1A of the present embodiment can vacuum-process workpieces 107 under the same temperature condition at vacuum processing unit 104.

The effect of reducing the difference in temperature condition is particularly remarkable in the case where a material of a larger heat capacity such as glass or resin is used as workpiece 107. In other words, if a workpiece of a smaller heat capacity is heated from the rear side or front side, a difference between respective temperatures of the rear side and the front side of the workpiece is unlikely to occur. In contrast, in the case of workpieces of a larger heat capacity, the temperature distribution of a workpiece heated from the rear side and that of a workpiece heated from the front side are different from each other, and a difference between respective temperatures of the front side and the rear side of a workpiece is likely to occur.

Further, in this case, since the first transport device (vacuum processing section transport device 202A) supports workpiece 107, it is unnecessary to separately provide a support member at vacuum processing unit 104 for supporting workpiece 107 and accordingly the number of components can be reduced. Furthermore, since the second transport device (loading section transport device 202B) supports workpiece 107, it is unnecessary to separately provide a support member at loading unit 108 for supporting workpiece 107, and accordingly the number of components can be reduced. In addition, since the third transport device (unloading section transport device 202C) supports workpiece 107, it is unnecessary to separately provide a support member at unloading unit 119 for supporting workpiece 107, and accordingly the number of components can be reduced.

Moreover, it is unnecessary to deliver and receive workpiece 107 between vacuum processing unit 104 and the transport mechanism, between loading unit 108 and the transport mechanism, and between unloading unit 119 and the transport mechanism. Therefore, workpiece 107 can be transported more stably and more speedily.

### Second Embodiment

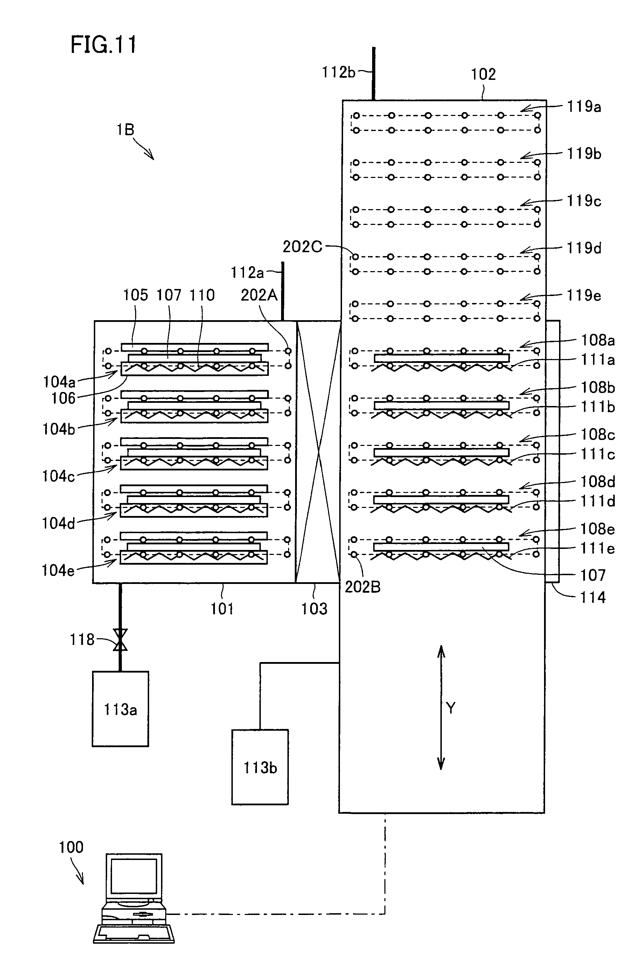

A vacuum processing device 1B of a second embodiment will now be described with reference to drawings. Fig. 11 is a schematic cross-sectional plan view showing vacuum processing device 1B of the present embodiment. While vacuum processing device 1B of the present embodiment is basically identical in configuration to vacuum processing device 1A of the first embodiment, the former differs from the latter in that the former includes in a vacuum processing chamber 101 a plurality of vacuum processing units 104 each constituted of a pair of a cathode electrode 105 and an anode electrode 106, and includes in a preparatory vacuum chamber 102 a plurality of loading units 108 and a plurality of unloading unit 119.

Specifically, as shown in Fig. 11, a plurality of pairs of cathode electrodes 105 and anode electrodes 106 are disposed in parallel at regular intervals (spaced from each other by a predetermined distance) in vacuum processing chamber 101, and cathode electrode 105 and anode electrode 106 of one pair are spaced by a predetermined distance. In the present embodiment, five pairs of cathode electrodes 105 and anode electrodes 106 are provided. Respective cathode electrodes 105 and respective anode electrodes 106 of the pairs constitute vacuum processing units 104a to 104e, respectively, and vacuum processing device 1A can vacuum-process five workpieces 107 at a time.

In preparatory vacuum chamber 102, a plurality of loading units 108a to 108e and a plurality of unloading units 119a to 119e are provided. The number of loading units 108a to 108e and the number of unloading units 119a to 119e each may be equal to or larger than the number of vacuum processing units 104a to 104e. Respective numbers of vacuum processing units 104, loading units 108 and unloading units 119 may be respective optimum numbers in terms of the time required for heating in preparatory vacuum chamber 102, and the time required for vacuum processing in vacuum processing chamber 101, for example.

In the present embodiment, the number of loading units 108a to 108e as provided and the number of unloading units 119a to 119e as provided are each five, which is equal to the number of vacuum processing units 104a to 104e. In direction Y perpendicular to transport direction X of workpiece 107, the loading units and the unloading units are both arranged at regular intervals (spaced from each other by a predetermined distance). As described above, loading units 108a to 108e and unloading units 119a to 119e are movable in direction Y perpendicular to transport direction X of workpiece 107, and are desirably configured to move together. In other words, loading units 108a to 108e and unloading units 119a to 119e are disposed along direction Y of movement of loading units 108a to 108e and unloading units 119a to 119e.

Heaters 111a to 111e are arranged at loading units 108a to 108e respectively so that loading units 108a to 108e are substantially identical to each other in terms of the relative positional relation (distance) between heaters 111a to 111e each and workpiece 107 held by a transport device 202B at loading units 108a to 108e. Namely, the relative positional relation between workpiece 107 and heater 111a contained in loading unit 108a is substantially identical to respective relations in other loading units 108b to 108e.

A plurality of loading units 108a to 108e are disposed so that the distance between workpieces 107 (workpiece surfaces 107a to be processed) held at loading units 108a to 108e respectively is substantially identical to the distance between workpieces 107 (workpiece surfaces 107a to be processed) held at a plurality of vacuum processing units 104a to 104e respectively. Likewise, a plurality of unloading units 119a to 119e are disposed so that the distance between workpieces 107 held at unloading units 119a to 119e respectively is substantially identical to the distance between workpieces 107 held at a plurality of vacuum processing units 104a to 104e respectively.

Vacuum processing device 1B of the present embodiment configured in the above-described manner can simultaneously transport a plurality of workpieces 107 from loading units 108a to 108e to vacuum processing units 104a to 104e. Likewise, vacuum processing device 1B of the present embodiment can simultaneously transport a plurality of workpieces 107 from vacuum processing units 104a to 104e to unloading units 119a to 119e. In the case where many workpieces 107 are to be processed, it is preferable to simultaneously transport workpieces 107, since the cycle time can be shortened.

In the present embodiment, workpiece 107 is placed (oriented) in a direction so that workpiece surface 107a to be processed is perpendicular to the horizontal plane. Workpiece 107, however, may be held at any angle like the first embodiment.

A vacuum processing method using vacuum processing device 1B of the present embodiment differs from the vacuum processing method of the first embodiment as illustrated in the flowchart of Fig. 4 in that, according to the former, a plurality of workpieces 107 are placed, loaded, unloaded, and removed at a time, namely a plurality of workpieces 107 are simultaneously vacuum-processed, and the former and the latter are similar in other respects.

According to the vacuum processing method of the present embodiment, a plurality of workpieces 107 are transported by a plurality of transport mechanisms. A plurality of workpieces 107 may be transported at different timings respectively. It is more preferable to transport a plurality of workpieces 107 at a time.

Vacuum processing device 1B of the present embodiment can preheat and vacuum-process a plurality of workpieces 107, and thus can perform vacuum processing efficiently. Further, workpieces 107 supported at different loading units 108 respectively are vacuum-processed by vacuum processing units 104 under respective temperature conditions substantially identical to each other, and thus the precision and reliability of vacuum processing are improved.

### Third Embodiment

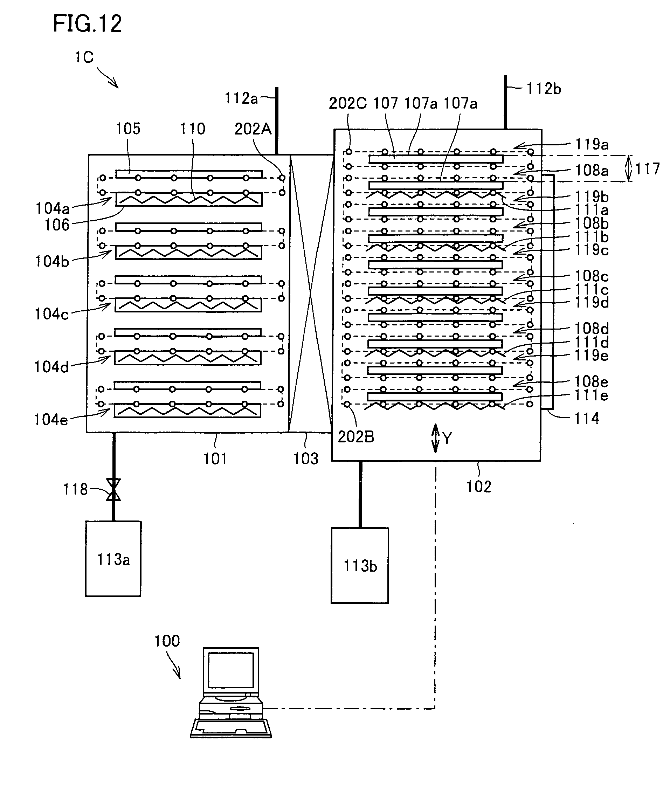

A vacuum processing device 1C of a third embodiment will be described with reference to drawings. Fig. 12 is a schematic cross-sectional plan view showing vacuum processing device 1C of the present embodiment. While vacuum processing device 1C of the present embodiment is basically similar to vacuum processing device 1B of the second embodiment, the former differs from the latter in that loading units 108a to 108e and unloading units 119a to 119e in a preparatory vacuum chamber 102 are arranged alternately along movement direction Y in the present embodiment.

Specifically, loading units 108a to 108e and unloading units 119a to 119e are disposed along movement direction Y of loading units 108a to 108e and unloading units 119a to 119e in the order, from the top to the bottom, of unloading unit 119a, loading unit 108a, and unloading units 119b to loading unit 108e.

Vacuum processing device 1C of the present embodiment is similar to vacuum processing device 1B of the second embodiment in that heaters 111a to 111e provided at loading units 108a to 108e are provided so that loading units 108a to 108e are identical to each other in terms of the relative positional relation between heaters 111a to 111e each and workpiece 107 held by a transport device 202B at loading units 108a to 108e each. In other words, the relative positional relation between heater 111a and workpiece 107 housed in loading unit 108a is identical to respective relations in other loading units 108b to 108e.

A plurality of loading units 108a to 108e are disposed so that the distance between workpieces 107 held at loading units 108a to 108e respectively is substantially identical to the distance between workpieces 107 held at a plurality of vacuum processing units 104a to 104e respectively. Likewise, a plurality of unloading units 119a to 119e are disposed so that the distance between workpieces 107 held at unloading units 119a to 119e is substantially identical to the distance between workpieces 107 held at a plurality of vacuum processing units 104a to 104e respectively.

The distance by which loading units 108a to 108e and unloading units 119a to 119e are moved is substantially identical to the distance between respective workpiece surfaces 107a of workpieces 107 held respectively at loading unit 108a and unloading unit 119a adjacent to each other. By way of example, as shown in Fig. 12, the loading units and unloading units are movable by the interval (distance) 117 between workpiece surface 107a of workpiece 107 held at loading unit 108e and workpiece surface 107a of workpiece 107 held at unloading unit 119e.

The distance by which loading units 108a to 108e and unloading units 119a to 119e are moved is shorter than that of the second embodiment, and the size of preparatory vacuum chamber 102 can be made smaller than that of vacuum processing device 1B of the second embodiment. Because the distance by which loading units 108a to 108e and unloading units 119a to 119e are moved is shorter, the relevant mechanism is simplified and the device is made compact.

A vacuum processing method of the present embodiment differs from the vacuum processing method of the second embodiment only in terms of the positions where workpieces 107 are placed in the workpiece placement steps (S10, S41, S84) and distance 117 by which loading units 108 and unloading units 119 are moved in the loading unit and unloading unit movement steps (S43, S60, S81, S83, S86), and they are similar to each other in other respects. In other words, in the present embodiment, the distance by which loading unit 108 move toward unloading unit 109 is smaller, and thus workpieces 107 are held at loading unit 108 and unloading unit 119 more stably. Further, because the time taken for moving loading unit 108 and unloading unit 119 is shortened, the total operating time of vacuum processing can be further shortened.

### Fourth Embodiment

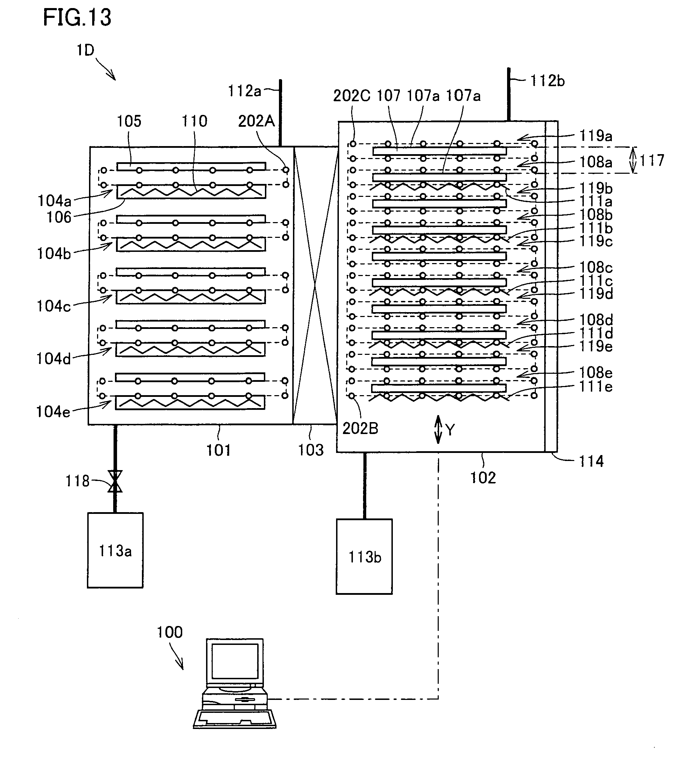

A vacuum processing device ID of a fourth embodiment will be described now with reference to drawings. Fig. 13 is a schematic cross-sectional plan view showing vacuum processing device ID of the present embodiment. While vacuum processing device ID of the present embodiment is used for a vacuum processing method similar to those of the first to third embodiments, the device of the present embodiment differs from vacuum processing devices 1A, 1B, 1C of respective embodiments in that the size of placement and removal door 114 is larger than that of vacuum processing device 1C.

Regarding vacuum processing device ID of the present embodiment, placement and removal door 114 is sized so that workpieces 107 can be introduced from the outside of preparatory vacuum chamber 102 and placed in loading units 108a to 108e (by an operator for example), and so that workpieces 107 held at unloading units 119a to 119e respectively can be removed from preparatory vacuum chamber 102 to the outside, without moving loading units 108a to 108e and unloading units 119a to 119e.

As described above in connection with the third embodiment, in vacuum processing device ID of the present embodiment as well, distance 117 by which loading units 108a to 108e and unloading units 119a to 119e are moved is shorter than that of vacuum processing device 1B of the second embodiment. Therefore, the size of placement and removal door 114 may be made larger than that of the third embodiment, so that an operator for example can place workpieces 107 at loading units 108a to 108e from the outside through placement and removal door 114, or can remove workpieces 107 from unloading units 119a to 119e through the door.

With the above-described configuration, the process for replacement of workpieces 107 can be simplified. Namely, the loading unit and unloading unit movement steps (S81, S83, S86) are unnecessary, and the vacuum processing method can thus be simplified. In other words, without moving loading units 108 and unloading units 119, workpieces 107 can be speedily placed at loading units 108. Further, workpieces 107 can be speedily removed from unloading unit 119 without moving loading units 108 and unloading units 119.

### First Modification of the Transport Mechanism

Regarding the first to fourth embodiments above, an example has been given where the transport mechanism or transport devices 202A, 202B, 202C for transporting workpiece 107 are constituted of components such as motor and rollers 202a, 202b, 202c. The form of the transport mechanism, however, is not limited to the above-described one. In the following, a first modification of the transport mechanism will be described.

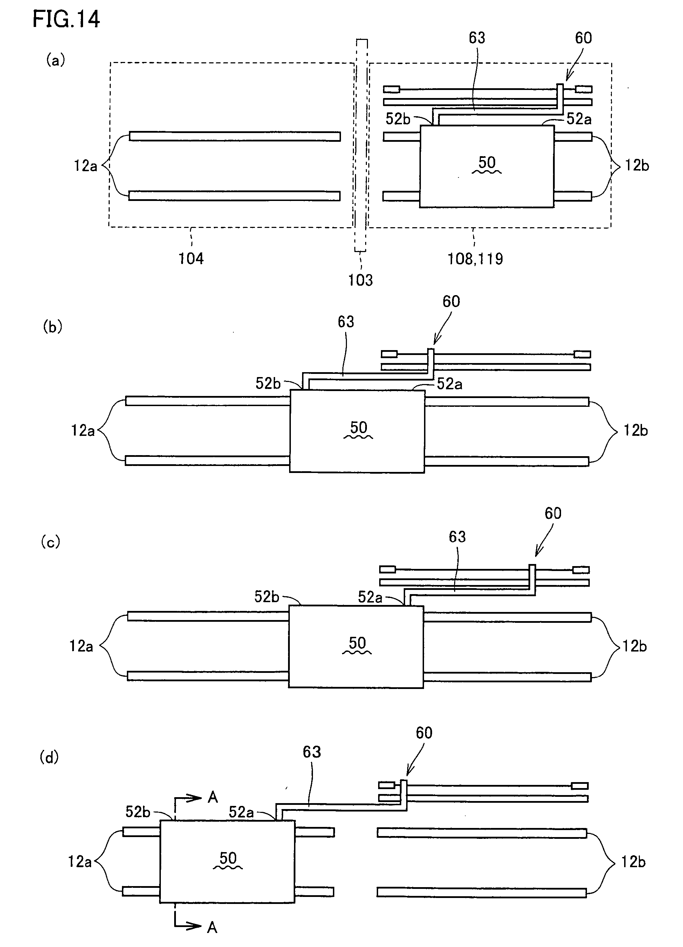

Fig. 14 is a schematic front view showing the modification of the transport mechanism. Specifically, Fig. 14 (a) is a schematic showing a state where a tray 50 on which workpiece 107 is mounted is located in loading unit 108 (or unloading unit 119), Fig. 14 (b) and Fig. 14 (c) are each a schematic showing a state where tray 50 is located between vacuum processing unit 104 and loading unit 108 (or unloading unit 119), and Fig. 14 (d) is a schematic showing a state where tray 50 is located in vacuum processing unit 104.

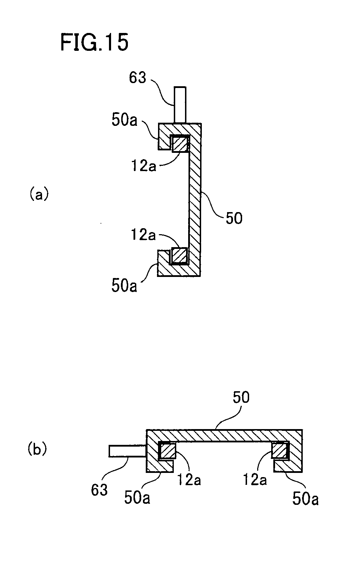

Fig. 15 is a cross section along arrow-headed line A-A in Fig. 14 (d). Specifically, Fig. 15 (a) is a side cross section of a modification where vertically disposed tray 50 is slid, and Fig. 15 (b) is a side cross section of a modification where horizontally disposed tray 50 is slid.

A description will be hereinafter given of a case where vertically disposed tray 50 is slid, with reference to the front views of Fig. 14 (a) to Fig. 14 (d) and the side cross section of Fig. 15 (a). It should be noted that tray 50 may be disposed horizontally. In the case where tray 50 is disposed horizontally, Fig. 14 (a) to Fig. 14 (d) are schematic plan views showing the modification of the transport mechanism, and a cross section along arrow-headed line A-A in Fig. 14 (d) is Fig. 15 (b). In the following, a description will be given of an operation performed when a transport arm 60 (transport mechanism) transports tray 50 with workpiece 107 mounted thereon from loading unit 108 to vacuum processing unit 104.

As shown in Fig. 14 (a) to Fig. 14 (d) and Fig. 15 (a), vacuum processing unit 104 of the present modification includes rod-like rails 12a for guiding the sliding movement (transport) of tray 50. Loading unit 108 includes rod-like rails 12b for guiding the sliding movement of tray 50. Unloading unit 119 includes rod-like rails 12b for guiding the sliding movement of tray 50. Like the embodiments as described above, vacuum processing unit 104 is adjacent to loading unit 108 and unloading unit 119 with gate valve 103 therebetween, and loading unit 108 includes transport arm 60 for moving tray 50 from loading unit 108 to vacuum processing unit 104 along rails 12a, 12b.

In the present modification, workpiece 107 is disposed on rails 12b of loading unit 108 together with tray 50, and removed from rails 12b of unloading unit 119 together with tray 50. Workpiece 107 can be disposed on either side of tray 50 as described later.

In the present modification, tray 50 (workpiece 107) is transported while gate valve 103 is opened and vacuum processing chamber 101 and preparatory vacuum chamber 102 communicate with each other, by transport arm 60 that moves tray 50 along rails 12a, 12b, from rails 12b of loading unit 108 to rails 12a of vacuum processing unit 104.

As shown in Fig. 15 (a) and Fig. 15 (b), rails 12a, 12b made of stainless each have a side cross section of substantially square in shape, and the surface of the rails is mirror-finished. Like the first to fourth embodiments above, rails 12a of vacuum processing unit 104 and rails 12b of loading unit 108 (unloading unit 119) are configured to be movable in the vertical direction to respective positions where rails 12a and rails 12b are aligned in the longitudinal direction of the rails. The distance from the end of rail 12a of vacuum processing unit 104 to the end of rail 12b of unloading unit 119 is 1300 mm, and tray 50 can be moved within this range of distance.

Tray 50 is also made of stainless and rectangular in shape as seen from the front side. One side of tray 50 that is opposite to rails 12a, 12b is mirror-finished for smoothly moving tray 50. Tray 50 has a width of 605 mm, a length of 900 mm and a thickness of 2 mm. At the upper end and the lower end of tray 50, latch portions 50a are formed that engage with rails 12a, 12b along the two sides parallel with the longitudinal direction of rails 12a, 12b while the tray is moved by transport arm 60. Latch portions 50a are shaped as if the opposing edges of tray 50 that are parallel with the longitudinal direction of tray 50 are bent to form a substantially right angle. In other words, tray 50 as seen in a side cross section is substantially C-shaped, so that tray 50 can slide while being guided by rails 12a, 12b.

A side of tray 50 has fit holes (engagement portions) 52a, 52b formed to engage with transport arm 60. Fit holes 52a and 52b of the side are formed at respective positions near the front end and near the rear end respectively in transport direction X of tray 50. In this way, tray 50 is transported by means of rails 12a, 12b and fit holes 52a, 52b are formed at the side of tray 50, so that workpiece 107 can be disposed on either surface of tray 50.

Transport arm 60 includes a wire 73 moved along transport direction X by a drive unit (not shown), and an arm unit 63 fastened to wire 73 and moved in parallel with wire 73. Arm unit 63 has a leading end formed to be inserted in and removed from fit holes 52a, 52b. Transport arm 60 is made of stainless. In other words, transport arm 60 moves by the same distance as the distance by which wire 73 moves.

How tray 50 of the vacuum processing device configured in the above-described manner is moved will be described hereinafter based on Fig. 14 (a) to Fig. 14 (d) and Fig. 15 (a). Fig. 14 (a) shows a state where workpiece 107 is disposed in loading unit 108, and tray 50 on which workpiece 107 is mounted is at a home position located on rails 12b of loading unit 108. First, the leading end of arm unit 63 of transport arm 60 is inserted in fit hole 52b located at the side on the front side in the direction of movement of tray 50. At this time, gate valve 103 serving as a partition between vacuum processing chamber 101 and preparatory vacuum chamber 102 is opened and vacuum processing chamber 101 and preparatory vacuum chamber 102 communicate with each other.

Next, as shown in Fig. 14 (a) and Fig. 14 (b), transport arm 60 is moved along transport direction X toward rails 12a (toward vacuum processing unit 104). Then, arm unit 63 is moved toward wire 73 and the leading end of arm unit 63 is removed from fit hole 52b.

Next, as shown in Fig. 14 (c), transport arm 60 is returned to the home position in loading unit 108, arm unit 63 is moved toward rails 12b, and the leading end of arm unit 63 is inserted in fit hole 52a located at the rear end of tray 50.

Then, as shown in Fig. 14 (c) and 14 (d), the second movement causes tray 50 to be transported to a home position located on rails 12a of vacuum processing unit 104. After this, the leading end of arm unit 63 is removed from fit hole 52a of tray 50. Finally, transport arm 60 is returned again to the home position in loading unit 108, and opened gate valve 103 is closed to separate again vacuum processing chamber 101 and preparatory vacuum chamber 102.

The operation for unloading tray 50 from vacuum processing unit 104 to unloading unit 119 may be performed oppositely to the above-described operation, and the description will not be repeated.

As described above, in the present modification (tray 50 is disposed vertically) as shown in Fig. 14 (a) to Fig. 14 (d) and Fig. 15 (a), a plurality of sets of rails 12a and a plurality of sets of rails 12b are provided in the front-rear direction (the direction perpendicular to the plane of Fig. 14), and the sets of rails 12a and the sets of rails 12b correspond respectively to vacuum processing units 104 and loading units 108 (or unloading units 119), respectively. Arm unit 63 is provided for each set of rails 12b.

The sets of rails 12b corresponding respectively to loading units 108 (or unloading units 119) are secured to a frame (not shown), and rails 12b and the frame move together in front-rear direction Y. Respective sets of rails 12a associated with respective vacuum processing units 104 may be secured to a frame (not shown), and rails 12a and the frame may move together in the top-bottom direction.

Further, a frame to which respective sets of rails 12b corresponding to loading units 108 are secured, and a frame to which respective sets of rails 12b corresponding to unloading units 119 are secured may move together in the direction (front-rear direction Y) perpendicular to transport direction X, or move separately in front-rear direction Y.

Respective arm units 63 for respective sets of rails 12b are provided at respective positions (in the front-rear direction) in such a manner that arm units 63 each do not shift in the top-bottom direction relative to the associated set of rails 12b. In other words, transport arm 60 moves together with loading unit 108 (or unloading unit 119) so that the relative positional relation between transport arm 60 and loading unit 108 (or unloading unit 119) remains the same.

It should be noted that transport arm 60 may be fixed in preparatory vacuum chamber 102 so that tray 50 can move between rails 12a and rails 12b while rails 12a of vacuum processing unit 104 and rails 12b of loading unit 108 (or unloading unit 119) are aligned in the longitudinal direction. In this case, transport arm 60 is fixed in preparatory vacuum chamber 102 and loading unit 108 (or unloading unit 119) can move separately from transport arm 60.

In this case, since transport arm 60 may be fixed in preparatory vacuum chamber 102 so that tray 50 can move between rails 12a and rails 12b, it is unnecessary to move only rails 12b for loading unit 108 (or unloading unit 119) in the front-rear direction so as to move transport arm 60. Therefore, the load of movement of the frame or the like to which rails 12b are secured is reduced.

In the present embodiment as shown in Fig. 14 (a) to Fig. 14 (d) and Fig. 15 (a), fit holes 52a, 52b are provided not at the upper surface but at the side surface of tray 50, arm unit 63 (transport arm 60) moves in the vertical direction, and arm unit 63 is inserted in fit holes 52a, 52b from above tray 50. It is unnecessary to provide the drive system (such as wire 73 and motor) of transport arm 60 for each rail set 12a. The drive system may be shared in vacuum processing chamber 101, and only arm units 63 may be separately provided to simultaneously transport a plurality of workpieces 107.

In the present modification, transport arm 60 is disposed on only one side (upper side as seen in Fig. 14) of tray 50. Transport arms 60 may be arranged on the opposite sides (upper side and lower side as seen in Fig. 14) respectively of tray 50. Transport arms 60 provided on both sides of tray 50, respectively, can make transport of tray 50 and workpiece 107 more stable.

In another modification shown in Fig. 14 (a) to Fig. 14 (d) and Fig. 15 (b) (tray 50 is horizontally disposed), a plurality of sets of rails 12a and a plurality of sets of rails 12b are provided in the vertical direction (perpendicular to the plane of Fig. 14), and the sets of rails 12a and the sets of rails 12b correspond to vacuum processing units 104 and loading units 108 (or unloading units 119), respectively. Arm unit 63 is provided for each set of rails 12a.

In order to prevent respective arm units 63 from shifting in the vertical direction relative to respective sets of rails 12a, arm units 63 may be provided at respective horizontal positions corresponding to respective sets of rails 12a associated with vacuum processing units 104. Transport arm 60 may be fixed in preparatory vacuum chamber 102 so that tray 50 can move between rails 12a and rails 12b while rails 12a of vacuum processing unit 104 and rails 12b of loading unit 108 (or unloading unit 119) are aligned along the longitudinal direction of the rails.

The present modification configured in the above-described manner provides the following effects. Since transport arm 60 is provided in preparatory vacuum chamber 102, only the devices necessary for vacuum processing may be placed in vacuum processing chamber 101, and thus the amount of impurities that enter vacuum processing chamber 101 can be reduced.

Further, one drive system (wire 73 or motor for example) may be provided and a plurality of arm units 63 branching from the drive system may be provided, so that a plurality of workpieces 107 can be transported at a time by means of the simple drive system. In other words, the simplified drive mechanism of transport arm 60 can reduce the size of transport arm 60 itself, so that the interval at which workpieces 107 are disposed can be decreased and a larger number of workpieces 107 can be housed even if the vacuum processing chamber 101 and preparatory vacuum chamber 102 of the same sizes are used. Second Modification of the Transport Mechanism A still another modification of the transport mechanism will be described hereinafter.

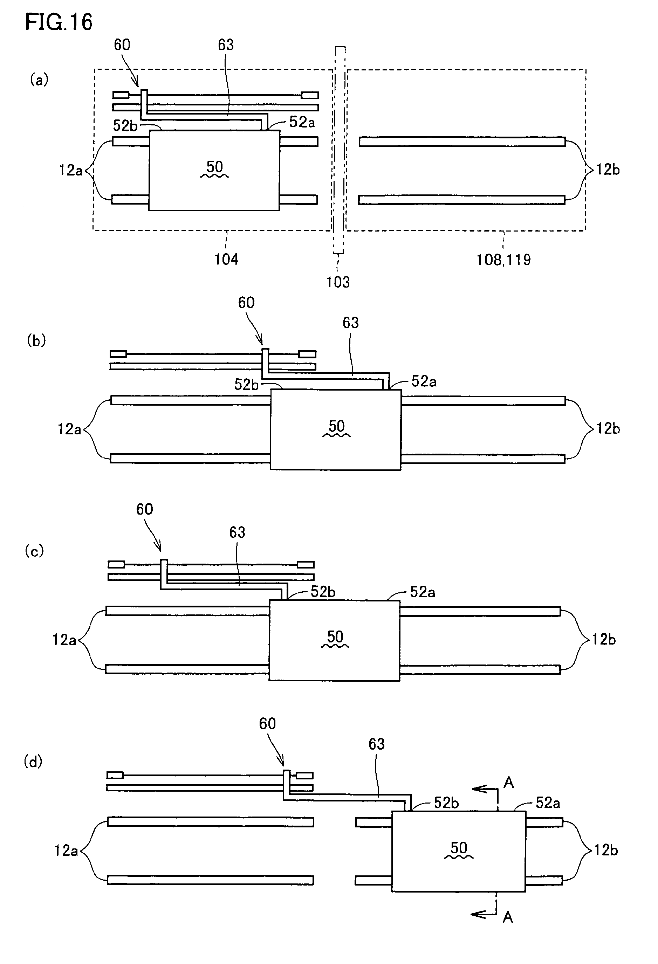

Fig. 16 is a schematic front view showing the modification of the transport mechanism. Specifically, Fig. 16 (a) is a schematic showing a state where tray 50 on which workpiece 107 is mounted is located in vacuum processing unit 104, Fig. 16 (b) and Fig. 16 (c) are each a schematic showing a state where tray 50 is located between vacuum processing unit 104 and loading unit 108 (or unloading unit 119), and Fig. 16 (d) is a schematic showing a state where tray 50 is located in loading unit 108 (or unloading unit 119).

The cross section along arrow-headed line A-A in Fig. 16 (d) is similar to the one shown in Fig. 15. With reference to the front view of Fig. 16 and the side cross section of Fig. 15 (a), a description will be given of the case where vertically disposed tray 50 is slid. In the case where tray 50 is disposed horizontally, Fig. 16 is a schematic front view showing the transport mechanism, and the cross section along arrow-headed line A-A in Fig. 16 (d) corresponds to Fig. 15 (b). In the following, an operation will be described that is performed when tray 50 on which workpiece 107 is mounted is transported from vacuum processing unit 104 to unloading unit 119.

In the present modification as well, workpiece 107 is disposed together with tray 50 on rails 12b for loading unit 108, and is removed from rails 12b of unloading unit 119 together with tray 50. Workpiece 107 may be disposed on either side of tray 50 as described later.

In the present modification as well, tray 50 (workpiece 107) is transported while gate valve 103 is opened and vacuum processing chamber 101 and preparatory vacuum chamber 102 communicate with each other, by transport arm 60 that moves tray 50 from rails 12a of vacuum processing unit 104 to rails 12b of unloading unit 119, along rails 12a, 12b.

The transport mechanism of the present modification differs from the above-described modification in that transport arm 60 is disposed at vacuum processing unit 104. Rails 12a, 12b, tray 50 and transport arm 60 as well as their configurations are similar to the above-described modification. Therefore, the description will not be repeated.

How tray 50 of the vacuum processing device configured in the above-described manner is moved will be hereinafter described based on Fig. 16 (a) to Fig. 16 (d) and Fig. 15 (a). Fig. 16 (a) shows a state where vacuum processing at vacuum processing unit 104 is completed and tray 50 on which workpiece 107 is mounted is at a home position located on rails 12a. First, the leading end of arm unit 63 of transport arm 60 is inserted in fit hole 52a at a side of tray 50 and located on the front side relative to the direction in which tray 50 is moved. At this time, gate valve 103 serving as a partition between vacuum processing chamber 101 and preparatory vacuum chamber 102 is opened and vacuum processing chamber 101 and preparatory vacuum chamber 102 communicate with each other.

Next, as shown in Fig. 16 (a) and Fig. 16 (b), transport arm 60 is moved along transport direction X toward rails 12b. Arm unit 63 is moved toward wire 73 and the leading end of arm unit 63 is removed from fit hole 52a.

Next, as shown in Fig. 16 (c), transport arm 60 is returned to the home position in vacuum processing unit 104, arm unit 63 is moved toward rails 12a, and the leading end of arm unit 63 is inserted in fit hole 52b located at the rear end of tray 50.

Next, as shown in Fig. 16 (c) and Fig. 16 (d), the second movement causes tray 50 to be transported to a home position located on rails 12b of unloading unit 119. After this, the leading end of arm unit 63 is removed from fit hole 52b of tray 50. Finally, transport arm 60 is returned again to the home position in vacuum processing unit 104, opened gate valve 103 is closed and vacuum processing chamber 101 and preparatory vacuum chamber 102 are separated again.

The operation when tray 50 is transported from loading unit 108 to vacuum processing unit 104 may be performed oppositely to the above-described operation, and the description will not be repeated.

In another modification (tray 50 is disposed horizontally) shown in Fig. 16 (a) to Fig. 16 (d) and Fig. 15 (b), a plurality of sets of rails 12a and a plurality of sets of rails 12b are arranged in the vertical direction (the direction perpendicular to the plane of Fig. 14), and the sets of rails 12a and the set of rails 12b correspond to vacuum processing units 104 and loading units 108 (or unloading units 119), respectively. Arm unit 63 is provided for each set of rails 12a. In order to prevent arm unit 63 from being shifted in the vertical direction relative to associated rails 12a, arm unit 63 is provided at the position corresponding to the associated set of rails 12a corresponding to vacuum processing unit 104.

The present modification configured in the above-described manner also provides the effect as follows. Specifically, transport arm 60 may be provided at only the system corresponding to vacuum processing unit 104. In the case where only loading unit 108 and unloading unit 119 are moved, it is unnecessary to move transport arm 60. Therefore, the load of movement of the frame to which rails 12b associated with loading unit 108 and unloading unit 119 are secured is reduced.

### Summary

While vacuum processing unit 104 performs vacuum processing on workpiece 107 in a first processing chamber (vacuum processing chamber 101), another workpiece 107 to be processed next is heated at loading unit 108 of a second processing chamber (preparatory vacuum chamber 102). After the vacuum processing, vacuum-processed workpiece 107 is unloaded to unloading unit 119 of the second processing chamber (preparatory vacuum chamber 102). Loading unit 108 and unloading unit 119 move in direction Y perpendicular to direction X in which workpiece 107 is loaded and transported by the transport mechanism. Workpiece 107 supported at loading unit 108 is loaded into vacuum processing unit 104 in vacuum processing chamber 101. While this workpiece 107 is vacuum-processed, new workpiece 107 is supported at loading unit 108. Workpiece 107 supported at unloading unit 119 is removed from the second vacuum chamber (preparatory vacuum chamber 102), and new workpiece 107 is preheated. In other words, workpieces 107 to be vacuum-processed in the first chamber (vacuum processing chamber 101) are efficiently replaced and accordingly the cycle time for vacuum processing devices 1A, 1B, 1C, 1D is shortened while the difference in temperature distribution between workpieces 107 to be vacuum-processed can be reduced.

The above-described embodiments (modifications) may be combined without changing the essential features thereof, and may be applicable to other embodiments.

It should be construed that embodiments disclosed herein are by way of illustration in all respects, not by way of limitation. It is intended that the scope of the present invention is defined by claims, not by the above description of the embodiments, and includes all modifications and variations equivalent in meaning and scope to the claims.

## Claims

1. A vacuum processing device (1A) for performing vacuum processing on a workpiece (107), comprising:
a first processing chamber (101) for housing said workpiece and performing vacuum processing on said workpiece,
said first processing chamber including a vacuum processing unit (104) for supporting said workpiece and performing vacuum processing on said workpiece;
an evacuatable second processing chamber (102) for housing a workpiece to be vacuum-processed and a workpiece having been vacuum-processed,
said second processing chamber including a loading unit (108) for supporting said workpiece to be vacuum-processed,
said loading unit having a heating device (111) for heating said workpiece to be vacuum-processed, and
said second processing chamber further including an unloading unit (119) for supporting said workpiece having been vacuum-processed;
a gate unit (103) provided between said first processing chamber and said second processing chamber and capable of blocking and allowing communication between said first processing chamber and said second processing chamber; and
a transport mechanism (202A) for transporting said workpiece to be vacuum-processed from said loading unit to said vacuum processing unit through said gate unit and transporting said workpiece having been vacuum-processed from said vacuum processing unit to said unloading unit through said gate unit.

2. The vacuum processing device according to claim 1, wherein
said loading unit and said unloading unit are arranged so that said loading unit and said unloading unit are spaced by a predetermined distance in an arrangement direction substantially perpendicular to a direction of loading said workpiece, and
said loading and unloading units and said vacuum processing unit are relatively movable by a relative distance in a relative direction of a pair of said loading unit and said unloading unit delivering and receiving the same workpiece via said vacuum processing unit.

3. The vacuum processing device according to claim 1, wherein
said first processing chamber includes a plurality of said vacuum processing units disposed in said arrangement direction,
said second processing chamber includes:
a plurality of said loading units disposed in said arrangement direction; and
a plurality of said unloading units disposed in said arrangement direction, and
said plurality of loading units are substantially identical in terms of relative positional relation between a surface to be processed of said workpiece supported by said loading unit and said heating device.

4. The vacuum processing device according to claim 3, wherein
an interval at which said plurality of loading units are arranged, an interval at which said plurality of unloading units are arranged and an interval at which said plurality of vacuum processing units are arranged are substantially identical.

5. The vacuum processing device according to claim 3, wherein
said loading units and said unloading units are disposed alternately in said arrangement direction.

6. The vacuum processing device according to any one of claims 1 to 5, wherein
said second processing chamber further includes a door (114) for feeding and removing said workpiece, and
said door has a dimension in said arrangement direction larger than a dimension in said arrangement direction of a portion where said loading unit and said unloading unit are arranged.

7. The vacuum processing device according to claim 1 or 2, wherein
said transport mechanism includes a first transport device disposed at said vacuum processing unit,
said first transport device supports said workpiece to be vacuum-processed,
said transport mechanism further includes a second transport device disposed at said loading unit,
said second transport device supports a workpiece to be vacuum-processed,
said first transport device and said second transport device load said workpiece to be vacuum-processed from said loading unit to said vacuum processing unit,
said transport mechanism further includes a third transport device disposed at said unloading unit,
said third transport device supports said workpiece having been vacuum-processed, and
said first transport device and said third transport device unload said workpiece having been vacuum-processed from the vacuum processing unit to the unloading unit.

8. The vacuum processing device according to any one of claims 3 to 5, wherein
said transport mechanism includes first transport devices disposed at said vacuum processing units, respectively,
said first transport devices support said workpieces to be vacuum-processed, respectively,
said transport mechanism further includes second transport devices disposed at said loading units, respectively,
said second transport devices support workpieces to be vacuum-processed, respectively,
said first transport devices and said second transport devices simultaneously load said workpieces to be vacuum-processed from said loading units to said vacuum processing units,
said transport mechanism further includes third transport devices of said unloading units, respectively,
said third transport devices support workpieces having been vacuum-processed, respectively, and
said first transport devices and said second transport devices simultaneously unload said workpieces having been vacuum-processed from the vacuum processing units to the unloading units.

9. A vacuum processing method for performing vacuum processing on a workpiece in a first processing chamber after heating said workpiece in a second processing chamber,
said second processing chamber including a loading unit and an unloading unit spaced by a predetermined distance in an arrangement direction in the second processing chamber,
the vacuum processing method comprising the steps of:
disposing a workpiece to be vacuum-processed in said loading unit;
evacuating said second processing chamber and heating said workpiece supported by said loading unit;
loading the workpiece to be vacuum-processed from said loading unit into said first processing chamber;
vacuum-processing said workpiece in said first processing chamber;
moving said loading unit and said unloading unit in said arrangement direction;
unloading the workpiece having been vacuum-processed from inside of said first processing chamber to said unloading unit;
opening said second processing chamber to atmosphere;
removing the workpiece having been vacuum-processed from said unloading unit; and
secondarily moving said loading unit and said unloading unit in a relative direction of said unloading unit with respect to said loading unit,
the step of opening said second processing chamber to atmosphere, the step of removing the workpiece having been vacuum-processed, the step of disposing the workpiece, and the step of heating the workpiece being executed while said step of vacuum processing the workpiece is performed, and
the step of unloading the workpiece, the step of moving said loading unit and said unloading unit and the step of loading the workpiece being executed after said step of vacuum-processing the workpiece.

10. A vacuum processing method using a vacuum processing device for performing vacuum processing on a workpiece in a first processing chamber after preheating said workpiece in a second processing chamber,
said vacuum processing device including:
the first processing chamber for housing said workpiece and performing vacuum processing on said workpiece,
said first processing chamber including a vacuum processing unit for supporting said workpiece and performing vacuum processing on said workpiece;
the second processing chamber evacuatable and housing a workpiece to be vacuum-processed and a workpiece having been vacuum-processed,
said second processing chamber including a loading unit for supporting said workpiece to be vacuum-processed,
said loading unit having a heating device for heating said workpiece to be vacuum-processed, and
said second processing chamber further including an unloading unit for supporting said workpiece having been vacuum-processed; and
a transport mechanism for transporting said workpiece to be vacuum-processed from said loading unit to said vacuum processing unit and transporting said workpiece having been vacuum-processed from said vacuum processing unit to said unloading unit,
said loading and unloading units and said vacuum processing unit being relatively movable, and
said vacuum processing method comprising the steps of:
heating said workpiece to be vacuum-processed by said heating device;
unloading the workpiece having been vacuum-processed from said vacuum processing unit to said unloading unit by said transport mechanism;
moving said loading unit and said unloading unit in a relative direction of the unloading unit with respect to said loading unit; and
loading a workpiece to be vacuum-processed from said loading unit to said vacuum processing unit by said transport mechanism.
